# EUROPÄISCHE PATENTSCHRIFT

(11) **EP 2 728 752 B1**
(45) Veröffentlichungstag und Bekanntmachung des Hinweises auf die Patenterteilung: **12.07.2017**
(21) Anmeldenummer: 13189641.7
(22) Anmeldetag: 22.10.2013
(51) Int. Cl.: H03K 17/955

(54) **Elektronische Sensoreinheit zur Erfassung einer berührungslosen Betätigung einer Tür oder Klappe an einem Kraftfahrzeug**
Electronic sensor unit for detecting a contact-free actuation of a door or hatch on a motor vehicle
Unité de détection électronique pour l'enregistrement d'un actionnement sans contact d'une porte ou d'un clapet sur un véhicule automobile

(30) Priorität: 31.10.2012 DE 102012110436
(43) Veröffentlichungstag der Anmeldung: 07.05.2014
(73) Patentinhaber: Huf Hülsbeck & Fürst GmbH & Co. KG, 42551 Velbert (DE)
(72) Erfinder: Sieg, Berthold, 46240 Bottrop (DE); Schindler, Mirko, 42549 Velbert (DE); Fratta, Stephan, 42855 Remscheid (DE); Montag, Patrick, 45219 Essen (DE); Gerdes, Bernd, 45355 Essen (DE)
(74) Vertreter: Zenz Patentanwälte Partnerschaft mbB

(56) Entgegenhaltungen:
- EP-A2- 1 471 360
- DE-T2- 60 214 233
- US-A1- 2003 071 640

## Beschreibung

Die Erfindung betrifft eine elektronische Sensoreinheit zur Erfassung der berührungslosen Betätigung einer Tür oder Klappe an einem Kraftfahrzeug.

Die Sensoreinheit weist ein Gehäuse auf, in welchem eine Steuer- und Auswerteeinheit angeordnet ist. Eine Sensorelektrode ist mit der Steuer- und Auswerteeinheit gekoppelt, um eine Kapazitätsänderung der Sensorelektrode bei Betätigung durch einen Benutzer zu erfassen.

Kapazitive Sensoranordnungen mit Sensorelektroden, mit deren Hilfe das Eindringen eines Objekts in einen Raum vor der Sensorelektrode erfasst wird, sind im Stand der Technik bekannt.

Eine mit der Sensorelektrode gekoppelte Steuer- und Auswerteschaltung erfasst eine Änderung der Kapazität der Sensorelektrode gegenüber einem Referenzpotential, beispielsweise indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Die Sensorelektrode reagiert dabei auf Annäherungen bzw. Berührungen von Objekten durch eine Kapazitätsänderung des aus der Sensorelektrode und dem Objekt gebildeten Kondensators. Dies lässt sich im Kern darauf zurückführen, dass die Kapazität eines Kondensators von seinem Plattenabstand abhängt. Im Regelfall erhöht sich dessen Kapazität je näher das Objekt der Sensorelektrode kommt.

Eine kapazitive Sensoranordnung mit einer Sensorelektrode, mit deren Hilfe die Annäherung eines Objekts erfasst werden soll, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Bei kapazitiven Sensoren werden Kapazitätsänderungen auch als Variationen der Auflade- und/oder Entladezeit der Kapazität einer Sensorelektrode ermittelt. Beispielsweise arbeitet der Sensor nach dem Ladungstransferprinzip. Eine Auswerteelektronik nach dem Ladungstransferprinzip benötigt dabei wenigstens einen Referenzkondensator welcher turnusmäßig aufgeladen wird, wobei die Aufladezeit bestimmt wird und als Referenzzeitspanne für die Auswertung von Annäherungen oder Berührungen eines Objektes verwendet wird. Es werden also Änderungen der Aufladezeit des Referenzkondensators ausgewertet, die durch Annäherungen eines Objektes an die Sensorelektrode modifiziert werden.

Derartige Sensoranordnungen können verwendet werden, um eine Tür oder Klappe eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten.

Die US2003/0071640 A1 offenbart eine Sensoranordnung mit einem Kunststoff-Hohlprofil, in welchem eine Sensorelektrode ausgebildet ist. Eine Steuerschaltung ist in einen Hohlraum des Profils eingeschoben und mit der Sensorelektrode gekoppelt.

Die DE 602 14 233 T2 beschreibt eine Gestaltung einer Sensoreinrichtung mit unterschiedlichen Empfindlichkeitsbereichen.

Aus der EP 1 471 360 A2 ist eine Anordnung für eine Sensorelektrode bekannt, wobei die Elektrode aus einem gebogenen oder gewundenen Draht gebildet ist.

Ein Problem mit den bekannten Einrichtungen besteht darin, dass es aufwändig ist, die Steuerelektronik und die zugehörigen Elektroden zu montieren. Insbesondere kommt es zu häufig zu Fehlmontagen oder Fehlschaltungen der Anordnungen. Außerdem sind Sensoranordnungen an verschiedene Fahrzeugmodelle aufwändig anzupassen.

Aufgabe der Erfindung ist es, eine verlässliche Sensorik bereitzustellen, welche die Montage erleichtert und sicher zu kontaktieren ist.

Erfindungsgemäß wird diese Aufgabe durch eine Sensoranordnung mit den Merkmalen des Anspruchs 1 gelöst.

Gemäß der Erfindung weist die Sensoreinheit eine Sensorelektrode auf, die auf einen flexiblen Träger angeordnet ist. Die Sensorelektrode ist als elektrisch leitfähige Leiterstruktur auf dem Träger ausgebildet und zusammen mit dem flexiblen Träger verformbar.

Der flexible Träger ist aus einem elektrisch isolierenden, beständigen Material gebildet. Insbesondere kommen Kunststoffmaterialien in Betracht. Die Sensorelektrode kann auf diesem Träger aufgeklebt sein, z.B. als Drahtanordnung oder metallische Folie. Der Träger schützt die Sensorelektrode vor übermäßigen Verformungen und vor zerstörender mechanischer Belastung. Der Träger erstreckt sich zusammen mit der Sensorelektrode wenigstens teilweise außerhalb des Gehäuses.

Erfindungsgemäß ist demnach die Sensoreinheit so ausgebildet, dass ein flexibler Träger aus dem Gehäuse der Sensoreinheit hinausgeführt ist oder an dem Gehäuse angeordnet ist. Der flexible Träger ist zusammen mit der daran befestigten Sensorelektrode nach Anordnung der Sensoreinheit an ihren Bestimmungsort, z.B. im Bereich des Stoßfängers, an die Formgestaltung des Fahrzeuges anzupassen. Gehäuse und Träger mit Elektrode bilden also eine gemeinsame Baugruppe. Da es sich um einen flexiblen Träger handelt, kann der Träger mit der Elektrode beispielsweise auf der Innenseite des Stoßfängers angeordnet werden, um die kapazitive Erfassung auf der zugehörigen Außenseite des Stoßfängers zu ermöglichen. Die flexible Ausführung des Trägers und der Elektrode gestatten eine Anpassung an verschiedenste Bauformen und -größen von Kraftfahrzeugen, ohne dass für jedes Fahrzeug eine individuelle Sensorelektrode bereitgestellt werden muss.

Der flexible Träger ist erfindungsgemäß als Flachmaterial in Gestalt einer Folie ausgebildet.

Ein derartiger flacher Träger ist auf einfache Art und Weise auf der Innenseite eines Detektionsbereiches zu befestigen und weist außerdem eine gewisse mechanische Stabilität in Richtung seiner Erstreckungsebene auf. Während er in Richtungen senkrecht zu der flächigen Ebene biegbar und verformbar ist, ist die Verformbarkeit in Richtung der Fläche selbst eher gering. Dies reduziert weiterhin die Montagefehlermöglichkeiten, wenn die Steuereinrichtungen in einer vorgegebenen Stelle am Fahrzeug montiert werden. Es ist bei dieser Gestaltung dann kaum möglich, den Elektrodendetektionsbereich versetzt zu der Sensoreinheit anzuordnen, da sich die Elektrode bei Verformungen in dieser Richtung widersetzt.

Die Elektrode kann auf dem Träger aufgeklebt sein oder aufgeschweißt oder aufgedampft. Es kann auch eine sonstige Art der Beschichtung oder Schichtstruktur ausgebildet werden.

Wesentlich ist, dass zu der Sensoreinheit eine Träger-Elektrodenstruktur mit flexibler Gestaltung kombiniert wird, um die Detektion für eine Vielzahl unterschiedlicher Kraftfahrzeuge zu ermöglichen.

In einer bevorzugten Ausgestaltung der Erfindung ist die Sensorelektrode als leitfähige Schichtstruktur auf dem Träger ausgebildet.

Während Drähte oder ähnliches auf dem Trägermaterial angeordnet und z.B. aufgeklebt werden können, ist die Ausbildung einer leitfähigen Schichtstruktur auf dem Träger besonders vorteilhaft. Die Schichtstruktur ermöglicht insbesondere bei dünnen Schichtdicken einen geringen Materialeinsatz, wobei gleichzeitig große Elektrodenflächen mit hoher Sensitivität auszubilden sind.

In einer bevorzugten Gestaltung wird außerdem die Sensorelektrode als ringförmiger Leiter auf dem Träger ausgebildet.

Die ringförmige Gestaltung einer Elektrode kann zu einer verbesserten Detektion führen und außerdem zu einer guten Detektierbarkeit von Elektrodenfehlern. Eine Ausführung als Ring kann sowohl bei der Montage als Gesteckt-Erkennung durch eine Spannungs- oder Widerstandsmessung zwischen dem Elektrodenenden verwendet werden als auch während des Betriebs für eine Überprüfung der Funktionsfähigkeit der Elektrode. Außerdem wird durch den von der Ringelektrode umgriffenen Raum eine verbesserte Detektionserfassung ermöglicht.

In der bevorzugten Ausführungsform der Erfindung ist der Träger mit der Elektrode durch das Gehäuse der Sensoreinheit hindurchgeführt und im Inneren des Gehäuses kontaktiert, um mit der Steuer- und Auswerteeinheit gekoppelt zu werden. Die komplett innenliegende Kontaktierung der Elektrode verringert die Fehleranfälligkeit, insbesondere wenn das Gehäuse gegen Umwelteinflüsse verkapselt ist.

Zu diesem Zweck ist es besonders bevorzugt, wenn der Durchtrittsbereich des Trägers mit der Sensorelektrode in das Gehäuse gedichtet ausgeführt ist, insbesondere vergossen.

In einer Weiterbildung der Erfindung ist der Träger mit der Elektrode derartig als Schichtstruktur ausgebildet, dass die Deckseiten der Träger-Elektrodenanordnung aus einem elektrisch isolierenden Deckmaterial gebildet sind. Das eigentliche Elektrodenmaterial, die leitfähige Metallschicht beispielsweise, liegt zwischen zwei elektrisch isolierenden Deckseiten in Gestalt einer Sandwich-Struktur. Auf diese Weise sind Umwelteinflüsse oder auch der Kontakt des Trägers mit elektrisch leitenden Bauteilen ohne Einfluss auf die Detektion durch die Sensoreinheit.

Es ist für die Montage des Systems besonders sinnvoll, wenn der Träger mit einer Klebeschicht oder eine Klebevorrichtung versehen ist, um ihn bei der Montage im Bereich der Detektionszone klebend zu befestigen. Dazu kann beispielsweise eine Klebeschicht mit einer Deckfolie versehen sein, die nach Anordnung der Sensoreinheit am Einbauort abgezogen wird, um den Träger mit der Elektrode zu fixieren. Dies ist deutlich einfacher als die bisherige Anordnung von langgestreckten Sensorelektroden, beispielsweise gebildet aus Kabeln, die mit Kabelhaltern auf der Innenseite von Fahrzeugstoßfängern fixiert werden müssen.

Die Erfindung wird nun anhand der beiliegenden Zeichnungen näher erläutert.

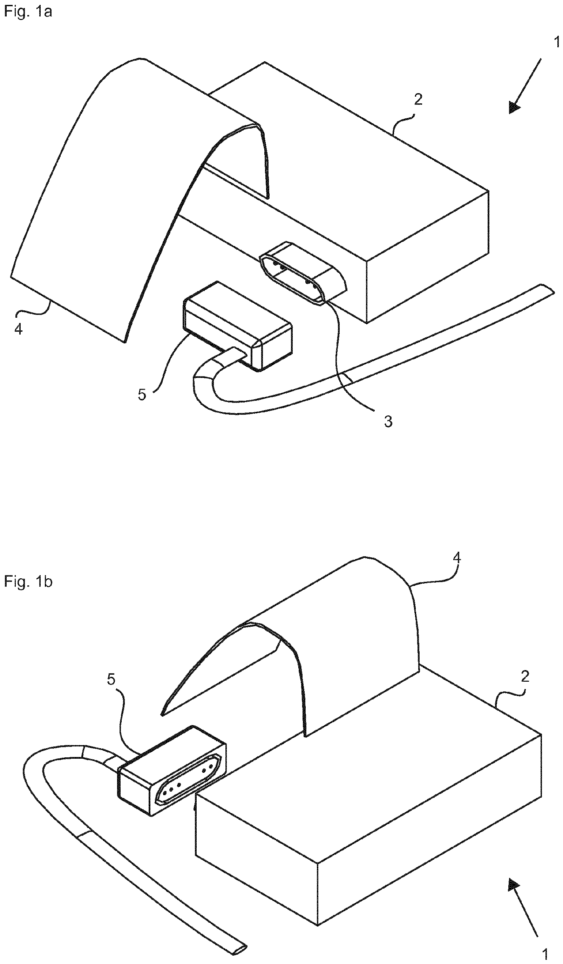

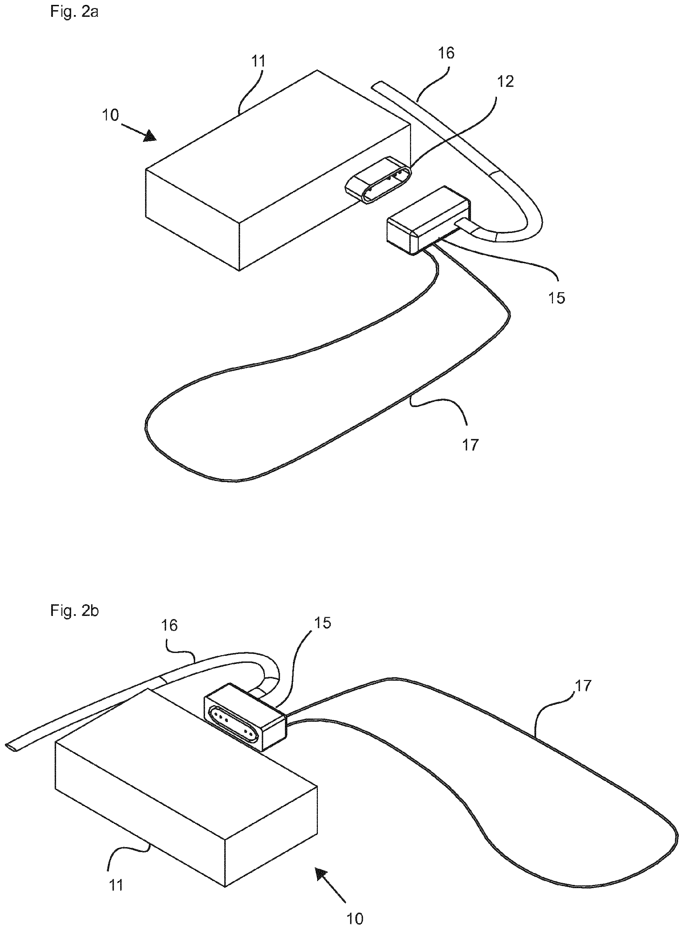

Figur 1a zeigt in schematischer Weise eine erste Ausführungsform einer Sensoreinheit gemäß der Erfindung mit einer Folienelektrode;
Figur 1b zeigt die Ausführungsform aus Figur 1a in einer anderen Ansicht;

In Figur 1a ist eine Sensoreinheit 1 gezeigt, die ein Gehäuse 2 und ein gehäuseseitigen Anschlussstecker 3 aufweist. In dem Gehäuse 2 ist eine Steuer- und Auswerteeinrichtung aufgenommen (nicht gezeigt), welche mit den Kontakten des Anschlusssteckers 3 gekoppelt ist. Ein flexibler Träger 4 ist mit einer Elektroden-Schichtstruktur versehen. Die Elektrode ist flächig als metallische Schicht auf dem Träger derart aufgebracht, dass der Träger 4 eine Grundschicht aus einem Kunststoff-Material, eine Zwischenschicht aus einem elektrisch leitfähigen Material und eine Deckschicht aus demselben Kunststoffmaterial aufweist. So sind die außenliegenden Bereiche des Trägers 4 elektrisch isolierend und umschließen die Sensorelektrode.

Dieser Träger-Elektrodenstreifen 4 ist durch eine Schlitzöffnung im Gehäuse 2 in das Gehäuse hineingeführt. Im Inneren des Gehäuses ist die Elektrodenschicht mit der Steuer- und Sensoreinheit elektrisch gekoppelt, um die Sensorelektrode 4 kapazitiv auszuwerten. Diese kapazitive Auswertung geschieht in derselben Form, wie bei den bisher bekannten und oben stehenden erläuterten kapazitiven Sensorsystemen. Dadurch, dass die Sensorelektrode 4 im Inneren des Gehäuses 2 kontaktiert ist, wobei die Träger-Elektrodenkombination zu diesem Zweck z.B. durchstoßen ist, um die innenliegende Elektrodenschicht zu kontaktieren, ist der Außenbereich der Elektrode geschützt. Der Durchtrittsbereich der Elektrode 4 durch das Gehäuse 2 ist mit einem flexiblen Kunststoffmaterial umgossen. Ein Steckverbinder 5 verbindet das Steuergerät mit dem Kabelbaum eines Fahrzeuges.

Es ist ersichtlich, dass die Ausbildung dieser Sensoreinheit den Vorteil bringt, dass die Sensoreinheit an einer geeigneten Stelle im Fahrzeug zu platzieren ist, beispielsweise auf der Innenseite eines Stoßfängers. Die flexible Elektrode 4 weist eine Klebeschicht auf oder wird mit einem Klebeelement versehen und nach Anordnung des Gehäuses an der Zielposition beispielsweise auf die Innenseite des Stoßfängers geklebt, um in unmittelbarer Anlage an den Stoßfänger sensitiv für Kapazitätsänderungen zu sein, die durch einen sich annähernden Benutzer hervorgerufen werden. Da die Sensorelektrode 4 flexibel und verformbar ist, können sowohl geringe Montageungenauigkeiten als auch die Strukturen unterschiedlicher Fahrzeuge ausgeglichen werden. Es ist außerdem möglich, für unterschiedliche Fahrzeugtypen unterschiedlich ausgeformte Elektrodenstreifen 4 vorzusehen. Auch gänzlich andere Gestaltungen der Elektrode 4 sind möglich, beispielsweise gefächerte Ausführungen des Trägers und der Elektrodenstruktur oder aber ringförmige Gestaltungen. Auch mehrere Träger und zugehörige Elektroden können problemlos auf diese Weise ausgebildet werden. Es ist außerdem möglich, die flexible Elektrode 4 mit einer Elektroden-Schichtstruktur zu versehen, so dass beispielswiese hintereinander die bei anderen kapazitiven Sensorelektroden verwendeten Elektrodenabfolgen aus Sensorelektrode und Schild-Elektrode verwendet werden können.

## Patentansprüche

1. Elektronische Sensoreinheit (1) zur Erfassung der berührungslosen Betätigung einer Tür oder Klappe an einem Kraftfahrzeug, wobei die Sensoreinheit ein Gehäuse (2) aufweist, in welchem eine Steuer- und Auswerteeinheit angeordnet ist und wobei eine Sensorelektrode mit der Steuer- und Auswerteeinheit gekoppelt ist, um eine Kapazitätsänderung der Sensorelektrode bei berührungsloser Betätigung durch einen Benutzer zu erfassen, wobei die Sensorelektrode auf einem flexiblen Träger (4) angeordnet ist, wobei die Sensorelektrode als elektrisch leitfähige Leiterstruktur auf dem Träger (4) ausgebildet ist, wobei die Sensorelektrode mit dem flexiblen Träger verformbar ist,
wobei der Träger sich mit der Sensorelektrode wenigstens teilweise außerhalb des Gehäuses (2) erstreckt,
**dadurch gekennzeichnet,**
**dass** der flexible Träger als Flachmaterial in Gestalt einer Folie ausgebildet ist.

2. Sensoreinheit nach Anspruch 1, **dadurch gekennzeichnet, dass** der Träger (4) mit der Elektrode durch eine Gehäusewandung in das Gehäuse (2) geführt ist, wobei die Elektrode im Innern des Gehäuses zur Kopplung mit der Steuer- und Auswerteeinheit kontaktiert ist.

3. Sensoreinheit nach Anspruch 2, wobei der Träger mit der Elektrode im Bereich der Durchführung in das Gehäuse gedichtet durchgeführt ist, insbesondere vergossen ist.

4. Sensoreinheit nach Anspruch 3, wobei der Träger und die Elektrode eine Schichtstruktur aufweisen, wobei die Deckseiten der Träger-Elektrodenanordnung aus einem elektrisch isolierenden Deckmaterial gebildet sind.

5. Sensoreinheit nach einem der vorstehenden Ansprüche, wobei der Träger mit einem Klebstoff versehen ist, um den Träger mit der daran befestigten Elektrode an einem Fahrzeugbauteil zu befestigen.

## Claims

1. Electronic sensor unit (1) for detecting the contact-free operation of a door or hatch on a motor vehicle, wherein the sensor unit has a housing (2) in which a control and evaluation unit is arranged and wherein a sensor electrode is coupled with the control and evaluation unit, in order to detect a change in capacitance in the sensor electrode on contact-free actuation by a user,
wherein the sensor electrode is arranged on a flexible carrier (4), wherein the sensor electrode is designed in the form of an electrically conductive conductor structure on the carrier (4), wherein the sensor electrode is deformable along with the flexible carrier,
wherein the carrier, together with the sensor electrode, extends at least partially outside of the housing (2),
**characterised in**
**that** the flexible carrier is a flat material in the form of a film.

2. Sensor unit according to claim 1, **characterised in that** the carrier (4), together with the electrode, is passed into the housing (2) through a housing wall, wherein the electrode makes contact inside the housing in order to be connected with the control and evaluation unit.

3. Sensor unit according to claim 2, wherein the carrier, together with the electrode, is fed sealed, more particularly cast, in the region of the passage, into the housing.

4. Sensor unit according to claim 3, wherein the carrier and the electrode have a layered structure, wherein the cover sides of the carrier-electrode arrangement are formed from an electrically insulating covering material.

5. Sensor unit according to one of the preceding claims, wherein the carrier is covered with an adhesive, in order to fix the carrier, together with the attached electrode, to a vehicle component.

## Revendications

1. Unité de détection (1) électronique destinée à la détection de l'actionnement sans contact d'une porte ou d'un hayon au niveau d'un véhicule automobile, dans laquelle l'unité de détection comporte un boîtier (2), dans lequel une unité de commande et d'évaluation est agencée et dans laquelle une électrode de détection est couplée à l'unité de commande et d'évaluation pour détecter une variation de capacité de l'électrode de détection lors de l'actionnement sans contact par un utilisateur,
dans laquelle l'électrode de détection est agencée sur un support (4) flexible, dans laquelle l'électrode de détection est réalisée sur le support (4) comme une structure de conducteurs électriquement conductrice, dans laquelle l'électrode de détection est déformable avec le support flexible,
dans laquelle le support s'étend avec l'électrode de détection au moins en partie en dehors du boîtier (2),
**caractérisée en ce**
**que** le support flexible est réalisé comme un matériau plat ayant la forme d'une feuille.

2. Unité de détection selon la revendication 1, **caractérisée en ce que** le support (4) avec l'électrode est guidé à travers une paroi de boîtier jusque dans le boîtier (2), dans laquelle l'électrode est mise en contact à l'intérieur du boîtier en vue du couplage à l'unité de commande et d'évaluation.

3. Unité de détection selon la revendication 2, dans laquelle le support avec l'électrode est guidé dans la zone de la traversée jusque dans le boîtier de façon étanche, il est en particulier scellé.

4. Unité de détection selon la revendication 3, dans laquelle le support et l'électrode présentent une structure en couches, dans laquelle les côtés de couverture de l'ensemble de supports-électrodes sont formés en un matériau de couverture électriquement isolant.

5. Unité de détection selon l'une des revendications précédentes, dans laquelle le support est muni d'un adhésif afin de fixer le support, avec l'électrode fixée dessus, à une pièce du véhicule.
